Europäisches Patentamt

European Patent Office

Office européen des brevets

(19)

(11) Veröffentlichungsnummer: **0 100 391**
**B1**

(12) **EUROPÄISCHE PATENTSCHRIFT**

(45) Veröffentlichungstag der Patentschrift: **04.04.90**

(21) Anmeldenummer: **83100151.6**

(22) Anmeldetag: **11.01.83**

(51) Int. Cl.⁵: **G 01 D 5/243**, G 05 B 19/33, G 05 B 19/35

(54) Schaltungsanordnung für ein zyklisch absolutes Lagemesssystem.

(30) Priorität: **31.07.82 DE 3228665**

(43) Veröffentlichungstag der Anmeldung:
**15.02.84 Patentblatt 84/07**

(45) Bekanntmachung des Hinweises auf die
Patenterteilung:
**04.04.90 Patentblatt 90/14**

(84) Benannte Vertragsstaaten:
**CH DE FR GB IT LI**

(56) Entgegenhaltungen:
**WO-A-82/01264**
**US-A-2 839 711**
**US-A-2 998 560**
**US-A-3 056 909**
**US-A-3 564 379**
**US-A-3 585 630**
**US-A-3 628 002**

(73) Patentinhaber: **ROBERT BOSCH GMBH**
**Postfach 50**
**D-7000 Stuttgart 1 (DE)**

(72) Erfinder: **Saul, Gert, Ing. grad.**
**Rubensstrasse 6**
**D-6120 Erbach (DE)**
Erfinder: **Meister, Werner, Ing. grad.**
**Pestalozzistrasse 4**
**D-6101 Reichelsheim (DE)**

(74) Vertreter: **Uhlig, Helge, Ing.-Grad.**
**ROBERT BOSCH GMBH Geschäftsbereich**
**Industrieausrüstung Patente und Lizenzen**
**Postfach 11 49**
**D-6120 Erbach/Odenwald (DE)**

EP 0 100 391 B1

## Beschreibung

Zur genauen Messung der relativen Lage zweier zueinander beweglicher Teile werden häufig Lagemeßtransformatoren wie zum Beispiel Resolver oder unter dem Warenzeichen Inductosyn bekannte Lagemeßsysteme verwendet. Zur Auswertung des Lagesignales werden hierbei digitale Verfahren mit Umsetzern eingesetzt. Ein solches Verfahren, das nach einer Amplitudenmethode, gemäß dem ersten Teil des Anspruches 1 arbeitet, wird in den deutschen Auslegenschriften 1 762 408, 1 956 881 und 2 048 427 beschrieben. Hierbei erfolgt ein Nullabgleich in einem Regelkreis, der Störimpulse, die auf den Lagemeßtransformator oder deren Zuleitungen gelangen, weitgehend auszugleichen vermag. Werden die in der Lage zu messenden Teile nicht oder nur langsam bewegt, wird durch den Regelkreis das Ausgangssignal des Lagemeßtransformators auf Null gehalten, während sich bei schnelleren Bewegungen ein Ausgangssignal ergibt, das angenähert einem Schleppfehler des Antriebes für diesen Teil entspricht.

Dieses Verfahren ist gegenüber Störungsimpulsen weitgehend unempfindlich. Ein Drahtbruch, ein Kurzschluß oder ein Schluß mit anderen spannungsführenden Teilen im Lagemeßtransformator, dessen Zuleitungen oder den elektronischen Bauteilen kann jedoch nicht ausgeschlossen werden. Durch derartige Fehler können sich falsche Lagemeßwertsignale ergeben, die insbesondere wenn diese Signale zum Steuern dieser Teile verwendet werden, zu Gefährdungen von Personen oder Material führen können. In diesen Fällen ist häufig eine Überwachung erforderlich, die derartige Fehler erkennt, anzeigt und/oder die Gefährdung, zum Beispiel durch ein schnelles Stillsetzen ausschließt oder gering hält. Während bei anderen Lagemeßverfahren häufig die Ausgangssignale des Lagemeßwertgebers überwacht werden, inwieweit diese eine Fehlergrenze überschreiten, ist dies bei dem hier verwendeten Verfahren wenig sinnvoll, da die am häufigsten zu erwartenden Fehler zu einem Ausgangssignal Null führen und bei abgeglichenem Regelkreis einer intakten Schaltung dieses Signal gleichfalls auf Null gehalten wird. Da ein Nullsignal dem üblicherweise gefahrlosen Stillstandssignal entspricht, können falsche oder gefährliche Bewegungen durch einen Fehler, der ein Nullsignal hervorruft, nicht erkannt werden.

Auch eine redundante Anordnung mit einem gleichen zweiten Lagemeßsystem, deren Ausgangsspannungen sich ständig gegenseitig überwachen, bringt neben einem hohen Aufwand und großen Anordnungsschwierigkeiten meist nicht den gewünschten Erfolg, da im Fehlerfall mit einer Nullausgangsspannung ein Fehler erst zu erkennen ist, wenn die gefahrbringende Bewegung schon eingesetzt hat.

Eine Aufgabe der Erfindung ist es, ohne wesentlichen Mehraufwand einen Test beziehungsweise eine Überwachung der Schaltungsanordnung nach dem ersten Teil des Patentanspruches 1, zu ermöglichen, die weitgehend alle möglichen Einzelfehler ·der Schaltungsanordnung erfaßt.

Erfindungsgemäß wird diese Aufgabe dadurch gelöst, daß ein Testgenerator vorgesehen ist, der bei laufender Messung während eines kurzen Testzeitraumes den Regelkreis für den Nullabgleich unterbricht, gleichzeitig dem Digital-Sinus-Kosinus-Generator zumindest ein Signal zuführt, das zu einer vorgegebenen Abweichung von der augenblicklichen Position führt und daß eine Fehlerauswertlogik vorgesehen ist, die das durch die Abweichung im Detektor entstehende Abgleichsignal abfragt und bei Unter- und/oder Überschreiten festgelegter Signalpegel ein Fehlersignal ausgibt.

Um auch Fehler erfassen zu können, die zu einem Ausgangssignal führen, das dem Testausgangssignal entspricht, kann in Wieterbildung der Erfindung dem Digital-Sinus-Kosinus-Generator während eines ersten Testzeitraumes ein Signal zugeführt werden, das einer vorgegebenen Abweichung in der einen Richtung entspricht und während eines zweiten Testzeitraumes eine gleichgroße Abweichung in der anderen Richtung hervorruft.

Wird die Lage der zueinander beweglichen Teile verändert, entsteht ein Abgleichsignal zur Nachstellung des Digital-Sinus-Kosinus-Generators. Diese Nachstellung wird während des Tests kurzzeitig unterbrochen. Um nun insbesondere bei großen Verstellgeschwindigkeiten keine größeren Abweichungen zu erhalten, kann eine Speicherschaltung vorgesehen werden, in welcher der letzte Wert des Abgleichsignals vor einer Testunterbrechung gespeichert wird, wobei über eine Umschalteinrichtung dieser gespeicherte Wert während des Testes dem Regelkreis zugeführt wird.

Die erfindungsgemäße Schaltungsanordnung läßt sich in besonders vorteilhafter Weise in prozessorgesteuerten numerischen Werkzeugmaschinensteuerungen verwenden, bei der die Stellung des Lagemeßtransformators zyklisch abgefragt wird und nach jeder derartigen Abfrage der Testgenerator, durch das Abfragesignal angestoßen, ‎einen Testzyklus veranlaßt. Nach jedem Test kann dann ein längerer Zeitabschnitt bis zur nächsten Abfrage folgen, in dem der Regelkreis erforderlichenfalls die Nachstellung des Digital-Sinus-Kosinus-Generators durchführt.

Je nach Anwendungsfall kann der Test in so kurzen Zeitabständen, zum Beispiel direkt nach dem Einschalten der Anlage und danach fortlaufend erfolgen, wobei ein Fehler im Lagemeßtransformator, deren Zuleitungen und der Auswertelektronik so rechtzeitig erfaßt wird, daß eine gefährliche Bewegung rechtzeitig unterbunden werden kann.

Im folgenden wird die Erfindung anhand von Ausführungsbeispielen erläutert, wie sie in den Zeichnungen dargestellt sind. Es zeigt

Fig. 1 das Blockschaltbild für ein Lagemeßsystem einer numerischen Steuerung,

Fig. 2 das Schaltbild eines Testgenerators,

Fig. 3 den Kurvenverlauf der Abgleichspannung für den Regelkreis,

Fig. 4 eine Umschaltlogik zur Verstimmung des Sinus-Kosinus-Generators und

Fig. 5 einen Speicherkreis für das Abgleichsignal und eine Schaltung zur Auswertung der Testsignale.

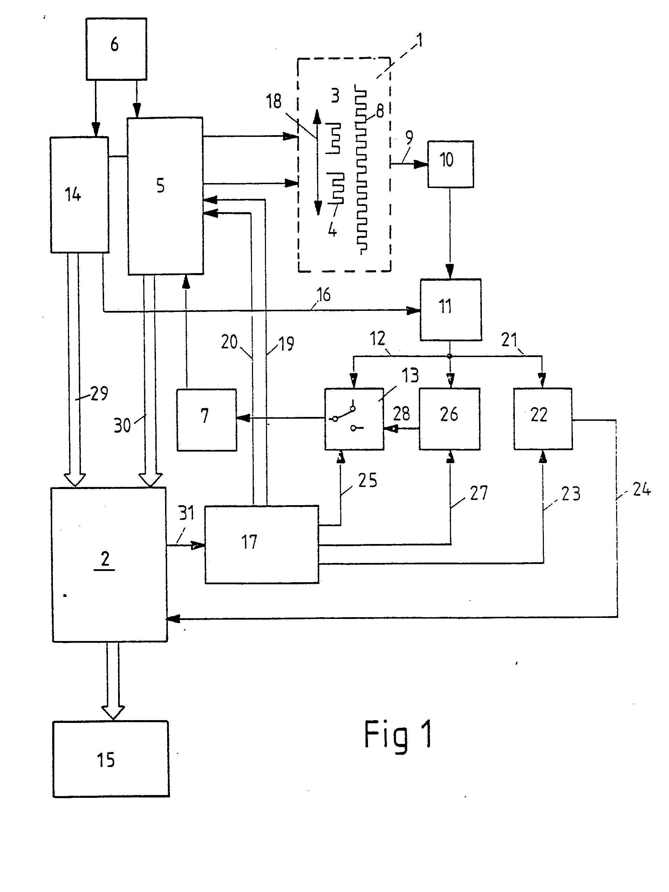

In Fig. 1 ist ein Lagemeßtransformator 1 dargestellt, der sowohl ein Resolver als auch ein unter dem Warenzeichen Inductosyn bekannter Lagewertgeber sein kann, dessen Stellung in einer numerischen Steuerung 2 ausgewertet wird. Hierzu werden—in an sich bekannter Weise—die Sinus- und Kosinus-Windungen 3 und 4 des Lagemeßtransformators 1 mit impulsbreitenmodulierten Rechteckimpulsen beaufschlagt, die in einem Sinus-Kosinus-Generator 5 erzeugt werden. Die Erzeugung erfolgt mit Hilfe von Zählstufen, die von einem hochfrequenten Taktgeber 6 und Impulsen aus einem Impuls- und Signal-Generator 7 unterschiedlich getaktet werden. Über die unterschiedlichen Zählerstände der Zählstufen werden unterschiedliche breite Impulse gleicher Frequenz erzeugt, die von den Windungen 3 und 4 auf die Ausgangswindungen 8 transformiert werden. Die Ausgangssignale 9 gelangen über einen Filter 10 auf einen Detektor 11, wobei der Filter 10 im wesentlichen nur die Grundwelle mit gleicher Frequenz durchläßt und hinter dem Filter 10 eine Wechselspannung mit konstanter Frequenz, jedoch unterschiedlichen Amplituden entsteht. Die Amplituden werden zu Null, wenn die im Sinus-Kosinus-Generator 5 erzeugten Signale einem elektrischen Stellungswert entsprechen, der bei der momentanen Lage der Windungen 3 und 4 zu den Ausgangswindungen 8 zu einem Nullwert in der Grundwelle führen. Im Detektor 11 wird eine der Amplituden der Wechselspannung entsprechende Abgleichspannung erzeugt, die über eine Leitung 12 und eine elektronische Umschaltstufe 13 dem Impuls- und Signal-Generator 7 zugeführt wird. Dieser Generator 7 erzeugt Impulse, deren Frequenz von der Größe der Abgleichspannung abhängig ist und Richtungssignale, die von der Polung der Abgleichspannung abhängen.

Der Aufbau der einzelnen Stufen 1 bis 11 kann hierbei entsprechend der in den deutschen Auslegeschriften 1 762 408, 1 956 881, 2 048 427 oder 2 205 364 angegebenen Weise erfolgen, wobei—wie dort gleichfalls ausgeführt—ein Referenzimpulszähler 14 vorgesehen ist, der gleichfalls von Taktgeber 6 getaktet wird und durch Zählstufenvergleich mit den Zählstufen im Sinus-Kosinusgenerator 5, der gemäß Fig. 1 in der Steuerung 2 erfolgt, Stellungssignale erstellt werden. Die Stellungssignale werden in der Steuerung 2 verarbeitet und/oder in einer Stellungsanzeige 15 angezeigt. Aus dem Referenzimpulszähler 14 kann—wie gleichfalls bekannt—über die Leitung 16 eine mit der Wechselspannung aus dem Filter 10 phasengleiche Impulsspannung abgegriffen sein, die im Detektor 11 dazu dient, die Polung der zweiten Halbwelle der Wechselspannung jeweils umzudrehen, so daß je nach Abweichrichtung nur positive oder negative Halbwellen entstehen.

In vielen Fällen, vor allem wenn die Lagemessung zur Steuerung einer Bewegung benutzt wird, die mit einer gleichartigen Bewegung 18 der Windungen 3 und 4 verknüpft ist, wird eine Fehlerüberwachung erforderlich, die verhindert, daß im Fehlerfall eine falsche Lage eingenommen oder eine für Material oder Personen gefahrbringende Bewegung erfolgt. Eine Überwachung des Ausgangssignales 9, das zur Erzeugung des Abgleichsignals dient, ist unzureichend, da im abgeglichenen Zustand dieses Signal zu Null wird und daher nicht mehr feststellbar ist, ob der geschlossene Meßkreis noch in Ordnung ist und bei den am häufigsten zu erwartenden Fehlern durch Unterbrechungen oder einen Kurzschluß das Ausgangssignal gleichfalls zu Null wird.

Erfindungsgemäß erfolgt die Fehlerüberwachung mit Hilfe eines Testgenerators 17, der während eines kurzen Testzeitraumes über die Leitungen 19, 20 Signale dem Sinus-Kosinus-Generator 5 zuführt, durch die dieser jeweils um einen festgelegten Betrag verstimmt wird. Hierdurch verändern sich schlagartig die Impulsbreiten der Ausgangssignale für die Windungen 3 und 4 in einer Weise, daß sich nach Transformation auf die Windungen 8 hinter dem Filter 10 eine Wechselspannung mit vorgegebener Amplitude ergibt. Entsprechend dieser Amplitude wird im Detektor 11 eine Abgleichspannung erzeugt, die über eine Leitung 21 einer Testlogik 22 zugeführt wird. Gleichzeitig erhält die Testlogik 21 vom Testgenerator 17 über die Leitung 23 einen Testimpuls, welcher die Testlogik veranlaßt dieses Signal zu überprüfen und im Falle einer falschen Abgleichspannung ein Fehlersignal zu liefern, das über die Leitung 24 der Steuerung 2 zugeführt wird.

Damit durch das während der Testzeit erzeugte Abgleichsignal kein Abgleich der Verstimmung im Sinus-Kosinus-Generator 5 erfolgt, liefert der Testgenerator 17 während der Testzeit ein Umschaltsignal über die Leitung 25 an die Umschaltstufe 13 und trennt hierbei den Regelkreis auf, so daß das Abgleichsignal über die Leitung 12 nicht mehr an den Impuls- und Signal-Generator 7 gelangen kann. Obwohl die Testzeit sehr kurz gehalten werden kann, wird bei schnellen Bewegungen 18 durch den während der Testzeit fehlenden Abgleich eine Verstimmung entstehen können, die nach Abschluß der Testzeit ausgeglichen werden muß und zu einer Unruhe im Regelkreis bzw. Schwingungen führen kann. Um dies zu vermeiden ist ein Speicher 26 vorgesehen, der zu Beginn der Testzeit durch einen Impuls aus dem Testgenerator über die Leitung 27 veranlaßt wird, den letzten Wert der Abgleichspannung aus dem Detektor zu speichern. Der gespeicherte Wert wird dann über die Leitung 28 dem Umschalter 13 zugeführt, der während der Testzeit diesen Wert dem Impuls- und Signal-Generator 7 zuführt. Hierdurch erfolgt auch während der Testzeit ein Abgleich, wobei lediglich Geschwindigkeitsänderungen während der Testzeit unberücksichtigt bleiben. Jeder Testzyklus kann durch Anstoßen des Testgenerators 17 mit einem Impuls erfolgen, der synchron nach dem Auslesen der Meßdaten erfolgt, z.B. mit der Rückflanke des Ausleseimpulses, der über die Leitung 31 an den Testgenerator 17 gelangt.

In Fig. 1 ist die Lagemessung einer numerischen Steuerung für nur eine Achse dargestellt. Sind mehrere Achsen mit Lagemeßtransformatoren 1 vorhanden, kann der Taktgeber 6, der Referenzimpulszähler 14 und der Testgenerator 17 auch für die weiteren Achsen verwendet sein. Das Fehlersignal kann dann einem Fehlerregister zugeführt sein, über das eine Anzeige möglich ist, die erkennen läßt, welche der Achsen einen Fehler in der Lagemessung aufweist. Die Steuerung 2 kann einen Prozessor enthalten, der in bekannter Weise zyklisch, zum Beispiel alle 8 ms, Zählerstände des Referenzzählers und eines Zählers im Sinus-Kosinus-Generator vom Datenbus 29 und 30 abfragt und aus der Differenz der beiden Zählerstände die Stellung der entsprechenden Achse ermittelt.

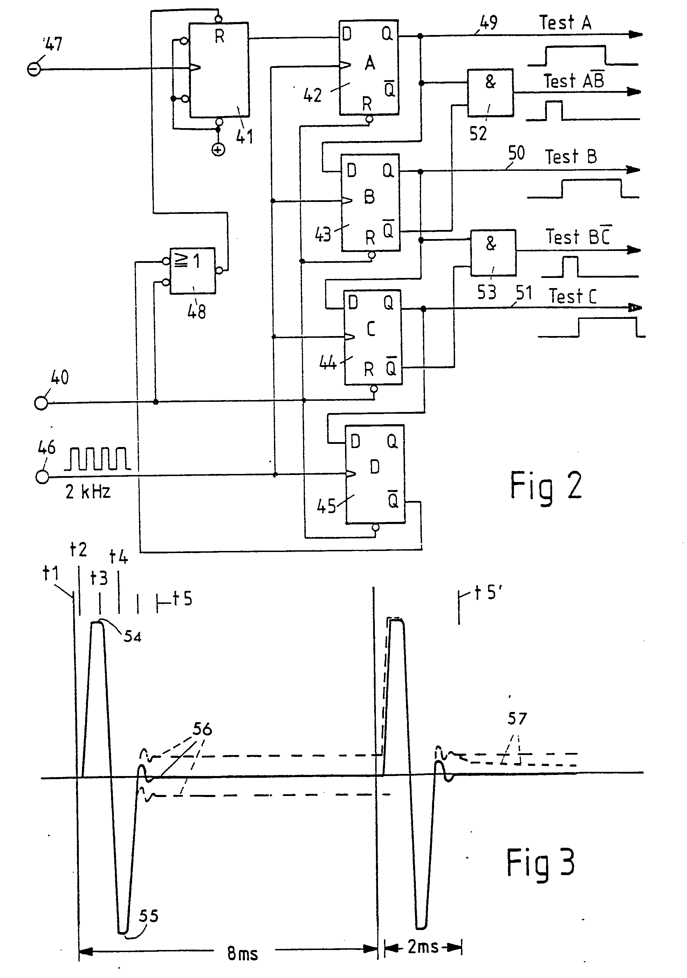

Der Testgenerator kann mit einem JK-Flipp-Flopp und vier D-Flipp-Flopps gemäß Fig. 2 aufgebaut sein, wobei durch einen an alle Flipp-Flopps an die R-Eingänge über den Anschluß 40 angelegten "Clear"-Impuls sichergestellt wird, daß sich diese im nicht gesetzten Ausgangszustand befinden. Während an den Takt-Eingang des JK-Flipp-Flopps 41 die vom Prozessor der Steuerung 2 erzeugten Ausleseimpulse geführt sind, liegt an allen vier D-Flipp-Flopps 42, 43, 44 und 45 eine 2 kHz Rechteck-Impulsspannung, die dem Referenzimpulszähler 14 entnommen sein kann und an den Anschluß 46 geführt ist. Die Q-Ausgänge der Flipp-Flopps 41, 42, 43 und 44 liegen jeweils am D-Eingang des nächsten Flipp-Flopps. Hierdurch bleiben alle D-Flipp-Flopps 42 bis 45 auch nach Ende des Clear-Impulses gesperrt.

Gelangt nun eine Ausleseimpuls über den Anschluß 47 auf den Takteingang des JK-Flipp-Flopps 41 wird dies gesetzt, wobei es über seinen Q-Ausgang das D-Flipp-Flopp 42 vorbereitet, das dann mit der nächsten positiven Flanke des 2 kHz-Signals gleichfalls gesetzt wird und hierdurch das nächste Flipp-Flopp vorbereitet. So wird durch das 2-kHz-Signal der Reihe nach alle 0,5 ms das jeweils nachfolgende D-Flipp-Flopp gesetzt. Mit dem Setzen des letzten D-Flipp-Flopps 45 gelangt über dessen Q̄-Ausgang ein Impuls über ein NOR-Glied 48 an den R-Eingang des JK-Flipp-Flopps 41 und setzt dieses zurück. Über den zweiten, negierten Eingang des NOR-Gliedes 48 wird der zuvor beschriebene Clear-Impuls vom Eingang 40 gleichfalls diesem R-Eingang zugeführt. So erfolgt durch das Setzen des D-Flipp-Flopps 45 ein Rücksetzen des JK-Flipp-Flopps 41 und hierdurch nach Eintreffen der nächsten positiven Flanke des 2 kHz-Signales ein Rücksetzen des D-Flipp-Flopps 42 und hierdurch der Reihe nach auch ein Rücksetzen der übrigen D-Flipp-Flopps 43 bis 45.

Die Q-Ausgänge 49, 50 und 41 der D-Flipp-Flopps 42, 43, 44 liefern die Testimpulsspannungen für die zum Test umzuschaltenden oder zu tastenden Stufen 13, 22, 26 und können auch der Verstimmung des Sinus-Kosinus-Generators 5 dienen. Bei dem im folgenden beschriebenen Ausführungsbeispiel erfolgt eine Verstimmung von jeweils + und −90° elektrisch, wozu zwei weitere Testimpulsspannungen verwendet werden, die je einem UND-Glied 52 und 53 entnommen werden.

Das UND-Glied 52 liegt mit einem Eingang am Q-Ausgang 49 des D-Flipp-Flopps 42 und ein zweiter Eingang liegt am Q̄-Ausgang des nächsten D-Flipp-Flopps 43. Die Eingänge des zweiten UND-Gliedes 53 liegen jeweils am Q-Ausgang 50 und am Q̄-Ausgang des nächsten Flipp-Flopps 44. So entstehen nach Beginn jedes Testzyklus drei jeweils um 0,5 ms versetzte Impulse Test A, B und C mit 2 ms Dauer und ein Testimpuls A$\overline{\mathrm{B}}$ mit 0,5 ms zu Beginn des Testimpulses A am UND-Glied 52, dem ein am UND-Glied 53 anliegender 0,5 ms-Impuls B$\overline{\mathrm{C}}$ folgt.

Zur Erläuterung der Testabläufe soll die Fig. 3 dienen, in welcher die Abgleichspannungen dargestellt sind, die am Ausgang des Detektors 11 anliegen. Erfolgt ein über die Leitung 31 (Fig. 1) am Anschluß 47 des Testgenerators liegenden Anstoßimpuls zum Zeitpunkt t 1, wird innerhalb von 0,5 ms der Testimpuls A zusammen mit dem Testimpuls A$\overline{\mathrm{B}}$ in t 2 begonnen. Mit dem Testimpuls A$\overline{\mathrm{B}}$ erfolgt eine Umschaltung im Sinus-Kosinus-Generator 5 um −90° elektrisch, wodurch die Abgleichspannung auf einen positiven Maximalwert 54 ansteigt. 0,5 ms später, mit Beginn des Testimpulses B zum Zeitpunkt t 3, erfolgt ein Abtasten dieses positiven Maximalwerts in der Testlogik 22 und gleichzeitig mit Beginn des Testimpulses B$\overline{\mathrm{C}}$ eine Umschaltung auf eine +90°-Verstimmung, durch welche die Abgleichspannung auf einen negativen Maximalwert 55 umspringt. Weitere 0,5 ms später mit t 4 erfolgt ein Abtasten dieses negativen Maximalwertes in der Testlogik 22 über die Vorderflanke des Testimpulses C. Da gleichzeitig der Testimpuls B$\overline{\mathrm{C}}$ hier endet, wird auch die Verstimmung rückgängig gemacht. Nach 1 ms zum Zeitpunkt t t ist mit dem Ende des Testimpulses A der Test abgeschlossen, und die Abgleichspannung hat sich auf den zum Testbeginn anliegenden Wert 56 eingestellt. Die Einstellung auf diesen Wert—der sich je nach Bewegungsrichtung (18) und Bewegungsgeschwindigkeit in Polung und Größe ändert—erfolgt, da durch Anlegen des Testimpulses A an dem Umschalter 13 während des ganzen Testzyklus der in einer "Sample & Hold"-Schaltung im Speicher 26 festgehaltene Wert den Kosinus-Sinus-Generator weiter nachgleicht, je nach dem welche Bewegung (18) zu Beginn der Testzeit bei t 2 registriert wurde.

Erfolgt der Testbeginn zum Beispiel während eines Abbremsvorganges von maximaler Geschwindigkeit auf Null, kann sich die Abgleichspannung entsprechend 57 laufend ändern, wobei durch den Testzyklus ein Fehler entsteht, der sich wie nach t 5' dargestellt rasch ausgleicht und sich nicht auf die Steuerung auswirkt, da der nächste Ausleseimpuls erst ca 6 ms später eintrifft. Die Abgleichspannung 56 ist üblicherweise wesentlich geringer als die Spannung bei einer 90°-Verstimmung, da der Aufbau des Meß- und Nachregelkreises so gewählt ist, daß man im linearen Bereich der Abgleichkurve arbeitet, die einer Sinuskurve entspricht. So kann im Impuls- und Signalgenerator 7 ein linear arbeitender Spannungs-Frequenzwandler verwendet werden, mit dem Impulse mit einer Frequenz erzeugt werden, die linear der Abweichung (Schleppfehler) aus bei großen Geschwindigkeiten der Bewegung (18) entsprechen.

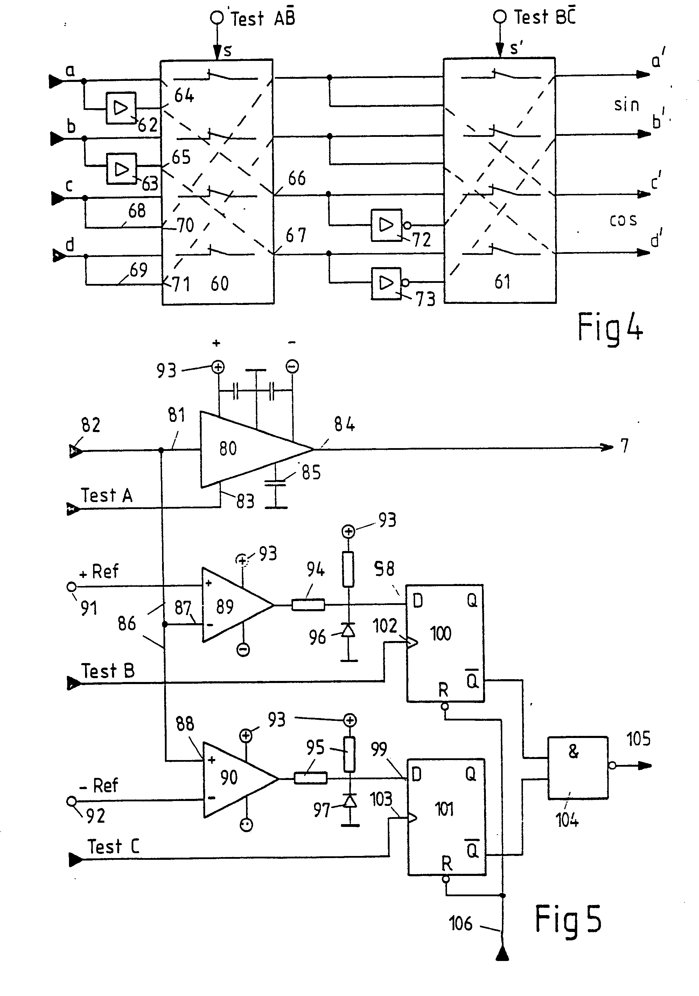

Eine ±90°-Verstimmung des Sinus-Kosinus-Generators läßt sich in einfacher Weise durch eine entsprechende Umschaltung der impulsbreitenmodulierten Signale für die Windungen 3 und 4 erzielen, wie dies in Fig. 4 dargestellt ist. Hier sind zwei gleichartig aufgebaute integrierte Bausteine 60 und 61 dargestellt, wie sie als Selektor/Multiplexer z.B. unter der Bezeichnung 74 LS 157 auf dem Markt erhältlich sind. Sie ermöglichen eine elektronische Umschaltung, wobei vier Ausgänge wahlweise an zwei verschiedenen der 8 Eingänge gelegt werden können. Die beiden Bausteine 60, 61 sind derart hintereinander geschaltet, daß ohne Schaltspannung am Strobe-Anschluß S und S' die ersten Eingänge a, b, c, d über durchgeschaltete Verbindungen der beiden Bausteine an den Ausgängen a', b', c', d' liegen. Der erste und der zweite Eingang a und b ist zusätzlich über je einen Negator 62 und 63 an je einen weiteren Eingang 64, 65 des ersten Bausteins 60 geführt, der mit einer Schaltspannung an S jeweils mit dem Ausgang 66, 67 verbunden ist, der über den zweiten Baustein 61 jeweils am Ausgang c' bzw. d' liegt. Auch die beiden anderen Eingänge c bzw. d sind über Leitungen 68 bzw. 69 an zwei weitere Eingänge 70 bzw. 71 geführt, die bei anliegender Schaltspannung an S über den zweiten Baustein 61 an den Ausgängen a' bzw. b' liegen. Der in Reihe hierzu liegende zweite Baustein ist in gleicher Weise beschaltet, wobei jedoch hier anstelle der direkten Leitungsverbindungen 68, 69 je ein weiterer Negator 72 und 73 zwischengeschaltet ist und die Negatoren 62 und 63 durch eine direkte Verbindung ersetzt sind.

Bei geschlossenem Regelkreis liegt zwischen den Eingängen a und b das impulsmodulierte Signal für die Sinuswindungen 3 und zwischen den Eingängen c und d das Signal für die Kosinuswindungen 4 an. Diese Signale sind über die beiden Bausteine direkt mit den Ausgängen a', b', c', d' verbunden, wobei die zwischen a' und b' liegenden Signale einem Endverstärker für die Sinuswindungen und die zwischen den Ausgängen c' und d' liegenden Signale einem weiteren Endverstärker für die Kosinuswindungen zugeführt werden. Am "Strobe"-Eingang S des ersten Bausteins 60 liegen die Testimpulse $A\bar{B}$ gemäß Fig. 2 und am "Strobe"-Eingang S' des zweiten Bausteins 61 die Testimpulse $B\bar{C}$. Solange kein Testimpuls anliegt, erfolgt keine Beeinflussung der impulsmodulierten Signale bzw. der Schaltung. Während eines Testimpulses $A\bar{B}$ schaltet der Bausteins 60 um und legt die Sinus-Signale negiert an die Kosinus-Windungen 4 und die Kosinus-Signale an die Sinus-Windungen. Hierdurch erfolgt eine Umschaltung des Sinus-Kosinus-Generators um −90° elektrisch, was einer extremen Plus-Abweichung des beweglichen Teiles entspricht, wobei im Detektor 11 eine positive Maximalspannung entsteht, um diese vermeindliche Abweichung auszugleichen.

Wird nach 0,5 ms der Testimpuls $A\bar{B}$ zurückgestellt und der Testimpuls $B\bar{C}$ an S' angelegt, gelangen an die Sinuswindungen 3 über den Endverstärker die negierten Kosinus-Signale und an die Kosinuswindungen 4 die Sinus-Signale. Dies entspricht einer Umschaltung um +90° elektrisch und es entsteht eine maximale negative Abgleichspannung, um den Meßwert zurückzustellen.

In Fig. 4 ist eine Schaltungsanordnung für die Stufen 13, 26, 22 gemäß Fig. 1 dargestellt. Die Stufen 13 und 26 sind hier in einem Baustein 80 zusammengefaßt, der aus einem marktüblichen Sample & Hold-Baustein z.B. SMP-11FY bestehen kann. Der Eingang 81 dieses Bausteins liegt am Ausgang 82 des Detektors 11, der die Abgleichspannung gemäß Fig. 3 führt. Solange am zweiten Eingang 83 des Bausteins 80 kein Testimpuls A (gemäß Fig. 2) anliegt, wird die Abgleichspannung unverändert vom Ausgang 84 dieses Bausteins zum Impuls- und Signalgenerator 7 geführt, der je nach Polung Richtungssignale und je nach Größe Impulse mit entsprechender Frequenz erzeugt. Liegt am Eingang 83 ein Testimpuls A an, wird der Eingang 81 gesperrt und ein Ausgangssignal abgegeben, das dem Signal entspricht, das bei der Sperrung angelegen hat, wozu ein "Hold"-Kondensator 85 dient.

Das Abgleichsignal gelangt vom Ausgang 82 des Detektors 11 über Leitungen 86 weiterhin an den Minuseingang 87 eines ersten Komparators 89 und den Pluseingang 88 eines zweiten Komparators 90 einer Testlogik (22). Am Pluseingang des Komparators 89 liegt eine + Referenzgleichspannung während an dem Minuseingang des Komparators 90 eine -Referenzgleichspannung 92 geführt ist. Die Referenzgleichspannungen 91 und 92 sind derart gewählt, daß bis zu einem jeweils vorgegebenen ± Extremwert der Abgleichspannung die Ausgänge beider Komparatoren 89 und 90 eine Spannung aufweisen, die annähernd den Wert des positiven Anschlusses 93 der Versorgungsspannung entspricht. Diese Ausgänge liegen jeweils an einem Spannungsteiler 94, 95 dessen anderes Ende jeweils mit dem Plus der Versorgungsspannung (93) verbunden ist. Am Abgriff dieser Spannungsteiler liegt jeweils ein-—durch eine Diode 96, 97 vor größeren negativen Spannungen geschützter—D-Eingang 98, 99 zweier D-Flipp-Flopps 100, 101. An dem Takt-Eingang 102 des ersten D-Flipp-Flopps 100 ist der Testimpuls B und an dem Takt-Eingang 103 des D-Flipp-Flopps 101 der Testimpuls C geführt. Die Vorderflanken dieser Testimpulse B oder C können die D-Flipp-Flopps 100 oder 101 jederzeit setzen, solange die D-Eingänge 98, 99 positiv beaufschalgt bleiben.

Liegt am Eingang 87 des Komparators 89 ein positiver Extremwert der Abgleichspannung an, welcher größer als der Wert der + Referenzspannung 91 ist, springt der Ausgang des Komparators auf einen negativen Wert um und sperrt hierbei den D-Eingang 98. Das gleiche erfolgt beim Komparator 90, wenn an dessen + Eingang 88 ein negativer Extremwert anliegt. Da im Testgenerator gemäß Fig. 2 sichergestellt ist, daß die Umschaltung gemäß Fig. 4 jeweils 0,5 ms vor der Vorderflanke der Impulse B bzw. C liegt, und das jeweilige Zurückschalten erst mit diesen Vorderflanken erfolgt. können bei fehlerfreiem Betrieb die Vorderflanken kein Setzen der D-Flipp-Flopps 100 oder 101 bewirken. Die so ständig positiven Q̄-Ausgänge können der Eingängen eines NAND-Gliedes 104 zugeführt sein, das bei Fehlen einer positiven Eingangsspannungen am negierten Ausgang 105 ein Fehlersignal liefert. Das Zurücksetzen der D-Flipp-Flopps 100 oder 101 kann durch einen Impuls über die Leitung 106 erfolgen, wenn sichergestellt ist, daß der Fehler behoben ist. z.B. nach erneutem Einschalten der Anlage.

Ist es erforderlich, können z.B. mit Hilfe von retriggerbaren Zeitgliedern, zusätzlich die Testimpulse B und C auf Vorhandensein überwacht werden, wobei ein Fehlen dieser Impulse gleichfalls zu einem Fehlersignal führt.

Das Abgleichsignal gemäß Fig. 3 wird in einem Detektor 11 gewonnen, der zwei Operationsverstärker enthält, zwischen denen ein elektronischer Analogschalter angeordnet ist. Der Analogschalter schaltet den zweiten Operationsverstärker bzw. dessen Eingangssignale derart um daß sich einmal eine Verstärkung von +1, umgeschaltet eine Verstärkung von −1 ergibt. Der vorgeschaltete Operationsverstärker ermöglich über eine Verstärkungseinstellung eine Optimierung des Regelkreises. Die Extremwerte bei der Testverstimmung liegen hierbei im Sättigungsbereich der Operationsverstärker, so daß sich keine Einschwingzeiten bei diesen Extremwerten ergeben, und eine ausgängliche Abgleichspannung keinen Einfluß auf diese Extremwerte hat.

Je nach den Anforderungen, den verwendeten integrierten Bausteinen und der Aufgabe der Überwachung, läßt sich die erfindungsgemäße Schaltungs anordnung in vielfacher Weise verändern. So ist es z.B. möglich, den Detektor 11 mit den Extremwerten nicht in den Sättigungsbereich zu steuern, um so von der Bewegungsgeschwindigkeit abhängige Testamplituden der Abgleichspannung zu erhalten. Durch eine entsprechende Einstellung der Referenzgleichspannungen 91 und 92 läßt sich dann ein Fehlersignal erzeugen, sobald die Bewegung eine Grenzgeschwindigkeit überschreitet.

**Patentansprüche**

1. Schaltungsanordnung für ein zyklisch absolutes Meßsystem mit einem Lagemeßtransformator zur Bestimmung der relativen Lage zweier zueinander beweglichen Teile mit einem Digital-Sinus-Kosinus-Generator, der impulsbreitenmodulierte Rechteckspannung für die Sinus- und Kosinuswindungen des Lagemeßtransformators liefert, an dessen Ausgangswindungen eine Wechselspannung abgegriffen wird, die über Filter einem Detektor zugeführt ist, der zum Nullabgleich ein Abgleichsignal aus den Amplituden dieser Wechselspannung erzeugt, das einem Impuls- und Signal-Generator zugeführt ist, der Impulse zur Nachstellung des Digital-Sinus-Kosinus-Generators liefert, dadurch gekennzeichnet, daß ein Testgenerator (17) vorgesehen ist, der bei laufender Messung während eines kurzen Testzeitraumes den Regelkreis für den Nullabgleich unterbricht, gleichzeitig dem Digital-Sinus-Kosinus-Generator (5) zumindest ein Signal (AB̄, BD̄) zuführt, das zu einer vorgegebenen Abweichung von der augenblicklichen Position führt, und daß eine Fehlerauswertlogik (22) vorgesehen ist, die das durch die Abweichung im Detektor (11) entstehende Abgleichsignal abfragt und bei Unter- und/oder Überschreiten festgelegter Signalpegel ein Fehlersignal ausgibt.

2. Schaltungsanordnung nach Anspruch 1, dadurch gekennzeichnet, daß dem Digital-Sinus-Kosinus-Generator (5) während eines ersten Testzeitraumes ein Signal (AB̄) zugeführt wird, das zu einer vorgegebenen Abweichung in einer Richtung führt, und während eines zweiten Testzeitraumes ein Signal (BC̄) zugeführt wird, das eine gleichgroße Abweichung in der anderen Richtung bewirkt.

3. Schaltungsanordnung nach einem der Ansprüche 1 oder 2, dadurch gekennzeichnet, daß der Detektor (11) eine Speicherschaltung (26) aufweist, in welcher der letzte Wert des Abgleichsignales vor einer Unterbrechung des Regelkreises gespeichert wird, und eine Umschalteinrichtung (13) vorgesehen ist, die während des Testzeitraumes dem Regelkreis den gespeicherten Wert des Abgleichssignales antelle des während des Testzeitraumes anliegenden Abgleichsignales zuführt.

4. Schaltungsanordnung nach einem der Ansprüche 1 bis 3 dadurch gekennzeichnet, daß dem Digital-Sinus-Kosinus-Generator (5) zyklisch während eines ersten Testzeitraumes ein Signal (AB̄) zugeführt ist, das eine Abweichung von +90° elektrisch bewirkt, anschließend während eines zweiten annähernd gleichlangen Testzeitraumes ein Signal (BC̄) zugeführt ist, das zu einer Abweichung von −90° elektrisch führt, und die Fehlerauswertlogik (22) das entsprechende Abgleichsignal dahingehend überwacht, inwieweit dies in ein vorgegebenes Spannungs-Zeit-Schema paßt.

5. Schaltungsanordnung nach einem der Ansprüche 1 bis 4 dadurch gekennzeichnet, daß eine Verstimmung des Sinus-Kosinus-Generators (5) um +90° elektrisch durch Umschalten der impulsbreitenmodulierten Signale des Sinus-Kosinus-Generators (5) erfolgt, wobei das Signal für die Sinuswindungen (3) während des Testzeitraumes an die Kosinuswindungen (4) gelegt wird und gleichzeitig das Signal für die Kosinuswindungen (4) invertiert den Sinuswindungen (3) zugeführt wird.

6. Schaltungsanordnung nach einem der Ansprüche 1 bis 4 dadurch gekennzeichnet, daß eine Verstimmung des Sinus-Kosinus-Generators (5) um −90° elektrisch durch Umschalten der impulsbreitenmodulierten Signale des Sinus-Kosinus-Generators (5) erfolgt, wobei das Signal für die Kosinuswindungen (4) während des Testzeitraumes an die Sinuswindungen (3) gelegt wird und gleichzeitig das Signal für die Sinuswindungen (3) invertiert den Kosinuswindungen (4) zugeführt wird.

7. Schaltungsanordnung nach einem der Ansprüche 5 und 6 dadurch gekennzeichnet, daß über einen ersten Testimpuls (AB̄) eine Umschaltstufe (60) eine Verstimmung von 90° elektrisch in der einen Richtung und über einen hieran anschließenden zweiten Testimpuls (BC̄) eine zweite Umschaltstufe (61) eine Verstimmung in der anderen Richtung durchführt, die in Reihe liegenden Umschaltstufen (60, 61) in nichtgeschaltetem Zustand die Sinuseingänge mit den Sinusausgängen und die Kosinuseingänge mit den Kosinusausgängen verbinden und bei anliegendem Testimpuls die Umschaltstufen (60, 61) eine entsprechende Überkreuzschaltung vornehmen, wobei in jeder Umschaltstufe Inverter (62, 63, 72, 73) vorgesehen sind, die entweder das Sinus- oder das Kosinus-Signal invertieren.

8. Schaltungsanordnung nach einem der Ansprüche 1 bis 7 für eine numerische Steuerung mit zumindest einem Prozessor für eine oder mehrere Maschinenachsen mit Lagemeßtransformatoren, dadurch gekennzeichnet, daß der Digital-Sinus-Kosinus-Generator (5) mit Zählstufen aufgebaut ist und einen für alle Achsen gemeinsamen Referenzzähler (14) enthält, die Abfrage der Zähler zyklisch durch den Prozessor erfolgt, der die Zählerstände vergleicht und aus dem Vergleich der Differenzen der Zählerstände die Stellung des Lagemeßtransformators ermittelt, der Prozessor nach jeder Abfrage den Testgenerator (17) anstößt, der einen Testzyklus veranlaßt, und nach Abschluß des Testzyklus ein längerer Zeitabschnitt bis zur nächsten Abfrage der Zählerstände durch den Prozessor vorgesehen ist, in dem der Regelkreis eine Nachstellung des Digital-Sinus-Kosinus-Generators (5) bewirkt.

9. Schaltungsanordnung nach einem der Ansprüche 1 bis 8 dadurch gekennzeichnet, daß unmittelbar vor einem Ansteuern der zueinander beweglichen Teile ein Testzyklus erfolgt und im Fehlerfall ein Fehlersignal ausgegeben wird, das die Ansteuerung der beweglichen Teile verhindert.

10. Schaltungsanordnung nach Anspruch 9 dadurch gekennzeichnet, daß unmittelbar nach dem Einschalten der Anlage unabhängig von einer Ansteuerung der zueinander beweglichen Teile ein Test erfolgt und der Test laufend in derart kurzen Zeitabständen wiederholt wird, in denen nur kleine Bewegungsabläufe möglich sind.

## Revendications

1. Dispositif de circuit pour un système de mesure cyclique absolue, avec un transformateur de mesure de position pour déterminer les positions relatives de deux pièces mobiles l'une par rapport à l'autre, avec un générateur numérique sinus-cosinus qui délivre des tensions rectangulaires modulées en largeur d'impulsions pour les enroulements sinus et cosinus du transformateur de mesure de position, aux enroulements de sortie duquel est prélevée une tension alternative, qui, par l'intermédiaire de filtres, est appliquée à un détecteur, lequel pour l'égalisation à zéro, produit un signal d'égalisation à partir des amplitudes de cette tension alternative, ce signal étant appliqué à un générateur d'impulsions et de signaux qui délivre des impulsions pour le repositionnement du générateur numérique sinus-cosinus, dispositif de circuit caractérisé en ce qu'il est prévu un générateur d'essai (17) qui, lors d'une mesure continue, interrompt pendant un court laps de temps d'essai, le circuit de réglage pour l'égalisation à zéro, et applique simultanément au générateur numérique sinus-cosinus (5) au moins un signal (AB, BD), qui se traduit par un écart prédéfini de la position instantanée, tandis qu'il est prévu une logique (22) d'exploitation de défaut, qui interroge le signal d'égalisation prenant naissance du fait de l'écart dans le détecteur (11), et qui, dans le cas d'un franchissement vers le bas et/ou vers le haut, du niveau de signal fixé, délivre un signal de défaut.

2. Dispositif de circuit selon la revendication 1, caractérisé en ce qu'un signal (AB) est appliqué au générateur numérique sinus-cosinus (5) pendant un premier laps de temps d'essai, ce signal se traduisant par un écart prédéfini dans un sens, et pendant un second laps de temps d'essai, un signal (BC) est appliqué qui provoque un écart de même grandeur dans l'autre sens.

3. Dispositif se circuit selon une des revendications 1 ou 2, caractérisé en ce que le détecteur (11) comporte un circuit de mémoire (26) dans lequel la dernière valeur du signal d'égalisation est mémorisée avant une interruption du circuit de réglage, et il est prévu un dispositif de commutation (13) qui pendant le laps de temps d'essai, applique au circuit de réglage la valeur mémorisée du signal d'égalisation au lieu du signal d'égalisation appliqué pendant le laps de temps d'essai.

4. Dispositif de circuit selon une des revendications 1 à 3, caractérisé en ce qu'un signal (AB) est appliqué cycyliquement pendant un premier laps de temps d'essai au générateur numérique sinus-cosinus (5), ce signal provoquant électriquement, un écart de +90°, et qu'ensuite, pendant un second laps de temps d'essai de longueur approximativement égale, un signal (BC) est appliqué, ce signal se traduisant électriquement par un écart de −90°, tandis que la logique d'exploitation de défaut (22) surveille le signal d'égalisation correspondant pour vérifier dans quelle mesure ce signal s'adapté à un schéma tension-temps prédéfini.

5. Dispositif de circuit selon une des revendications 1 à 4, caractérisé en ce qu'un désaccord de +90° du générateur sinus-cosinus (5) s'effectue par commutation des signaux modulés en largeur d'impulsion du générateur sinus-cosinus (5), le signal pour les enroulements sinus (3) étant appliqué pendant le laps de temps d'essai aux enroulements cosinus (4), tandis que simultanément, le signal pour les enroulements cosinus (4) est appliqué après inversion aux enroulements sinus (3).

6. Dispositif de circuit selon une des revendications 1 à 4, caractérisé en ce qu'un désaccord de −90° du générateur sinus-cosinus (5) est effectué électriquement par commutation des signaux modulés en largeur d'impulsion du générateur sinus-cosinus (5), le signal pour les enroulements cosinus (4) étant appliqué pendant le laps de temps d'essai aux enroulements sinus (3), tandis que simultanément, le signal pour les enroulements sinus (3) est appliqué après inversion aux enroulements cosinus (4).

7. Dispositif de circuit selon une des revendications 5 et 6, caractérisé en ce que, par l'intermédiaire d'une première impulsion d'essai (AB), un premier étage de commutation (60) provoque électriquement un désaccord de 90° dans un sens, tandis que par l'intermédiaire d'une seconde impulsion d'essai (BC) se raccordant à la première, un second étage de commutation (61) provoque un désaccord dans l'autre sens, ces étages de commutation (60, 61) placés en séries reliant à l'état non branché, les entrées sinus avec les sorties sinus, et les entrées cosinus avec les sorties cosinus, tandis que lorsqu'une impulsion d'essai est appliquée, les étages de commutation (60, 61) procèdent à un branchement croisé approprié, tandis que dans chaque étage de commutation, des inverseurs (62, 63, 72, 73) sont prévus qui inversent, soit le signal sinus, soit le signal cosinus.

8. Dispositif de circuit selon une des revendications 1 à 7 pour une commande numérique avec au moins un processeur pour un ou plusieurs axes de machines avec des transformateurs de mesure de position, dispositif de circuit caractérisé en ce que le générateur numérique sinus-cosinus (5) est constitué avec des étages de comptage et comporte un compteur de référence (14) commun à tous les axes, l'interrogation de ce compteur s'effectuant cycliquement par le processeur, qui compare les étages de comptage et par comparaison des différences entre ces étages de comptage, détermine la position du transformateur de mesure de position, le processeur déclenchant après chaque interrogation, le générateur d'essai (17) qui autorise un cycle d'essai, et après la fin du cycle d'essai, un laps de temps plus long est prévu jusqu'à la prochaine interrogation des étages de comptage par le processeur, dans lequel le circuit de réglage provoque un repositionnement du générateur numérique sinus-cosinus (5).

9. Dispositif de circuit selon une des revendications 1 à 8, caractérisé en ce que, directement avant une commande des parties mobiles l'une par rapport à l'autre, un cycle d'essai est effectué et en cas de défaut, un signal de défaut est délivré, ce signal empêchant la commande des pièces mobiles.

10. Dispositif de circuit selon la revendication 9, caractérisé en ce que, directement après la mise en circuit de l'installation, indépendamment d'une commande des parties mobiles l'une par rapport à l'autre, un essai est effectué et l'essai est répété en continu à des intervalles de temps suffisamment courts pour que seuls des déplacements réduits soient possibles dans ces intervalles.

**Claims**

1. Circuit arrangement for a cyclically absolute measuring system comprising a position sensing transformer for determining the relative position of two parts which can be moved with respect to one another, with a digital sine/cosine generator which supplies pulse-width-modulated rectangular voltages for the sine and cosine windings of the position sensing transformer, at the output windings of which an alternating voltage is picked up which is supplied via filters to a detector which generates, for zero calibration, a calibration signal from the amplitudes of this alternating voltage which signal is supplied to a pulse and signal generator which supplies pulses for correcting the digital sine/cosine generator, characterized in that a test generator (17) is provided which, during continuous measurement, interrupts the control loop for the zero calibration during a short test period, at the same time supplies at least one signal (AB, BD) to the digital sine/cosine generator (5) which leads to a predetermined deviation from the instantaneous position, and in that a fault analysis logic (22) is provided which samples the calibration signal produced by the deviation in the detector (11) and outputs a fault signal when the calibration signal drops below and/or exceeds fixed signal levels.

2. Circuit arrangement according to Claim 1, characterized in that the digital sine/cosine generator (5) is supplied during a first test period with a signal (AB) which leads to a predetermined deviation in one direction, and is supplied during a second test period with a signal (BC) which results in an equally large deviation in the other direction.

3. Circuit arrangement according to one of Claims 1 or 2, characterized in that the detector (11) exhibits a storage circuit (26) in which the last value of the calibration signal before an interruption of the control loop is stored, and a switchover device (13) is provided which, during the test period, supplies to the control loop the stored value of the calibration signal instead of the calibration signal present during the test period.

4. Circuit arrangement according to one of Claims 1 to 3, characterized in that a digital sine/cosine generator (5) is cyclically supplied during a first test period with a signal (AB) which produces a deviation of +90° electrical, is subsequently supplied during a second approximately equally-long test period with a signal (BC) which leads to a deviation of −90° electrical, and the fault analysis logic (22) monitors the extent to which the corresponding calibration signal fits within a predetermined voltage/time scheme.

5. Circuit arrangement according to one of Claims 1 to 4, characterized in that the sine/cosine generator (5) is detuned by +90° electrical by switching-over the pulse-width-modulated signals of the sine/cosine generator (5), the signal for the sine windings (3) being applied to the cosine windings (4) during the test period and, at the same time, the signal for the cosine windings (4) being supplied inverted to the sine windings (3).

6. Circuit arrangement according to one of Claims 1 to 4, characterized in that the sine/cosine generator (5) is detuned by −90° electrical by switching-over the pulse-width-modulated signals of the sine/cosine generator (5), the signal for the cosine windings (4) being applied to the sine windings (3) during the test period and, at the same time, the signal for the sine windings (3) being supplied inverted to the cosine windings (4).

7. Circuit arrangement according to one of Claims 5 and 6, characterized in that a switch-over stage (60) carries out via a first test pulse (AB) a detuning of 90° electrical in one direction and a second switch-over stage (61) carries out via a subsequent second test pulse (BC) a detuning in the other direction, the series-connected switch-over stages (60, 61) connect, in the non-switched state, the sine inputs to the sine outputs and the cosine inputs to the cosine outputs and, when the test pulse is present, the switch-over stages (60, 61) carry out a corresponding cross-over switching, inverters (62, 63, 72, 73) which either invert the sine or the cosine signal being provided in each switch-over stage.

8. Circuit arrangement according to one of Claims 1 to 7 for a numeric control system having at least one processor for one or several machine axes with position sensing transformers, characterized in that the digital sine/cosine generator (5) is configured with counting stages and contains a reference counter (14) which is common to all axes, the counters are cyclically sampled by the processor which compares the counts and determines from the comparison of the differences of the counts the position of the position sensing transformer, the processor triggers after each sampling the test generator (17) which initiates a test cycle and after conclusion of the test cycle a relatively long time interval to the next sampling of the counts by the processor is provided during which the control loop effects a correction of the digital sine/cosine generator (5).

9. Circuit arrangement according to one of Claims 1 to 8, characterized in that a test cycle occurs immediately before an activation of the parts which can be moved with respect to one another and in the case of a fault a fault signal is output which prevents the moving parts from being actuated.

10. Circuit arrangement according to Claim 9, characterized in that, immediately after the system has been switched on, a test occurs independently of any actuation of the parts which can be moved with respect to one another and the test is continuously repeated in time intervals which are short enough that only short sequences of movement are possible.

Fig 1

Fig 2

Fig 3

2

EP 0 100 391 B1

Fig 4

Fig 5

3